(19)

Europäisches Patentamt
European Patent Office
Office européen des brevets

(11) **EP 3 306 685 B1**

(12) **EUROPEAN PATENT SPECIFICATION**

(45) Date of publication and mention
of the grant of the patent:
**19.08.2020 Bulletin 2020/34**

(21) Application number: **16744433.0**

(22) Date of filing: **06.06.2016**

(51) Int Cl.:
*H01L 35/22* (2006.01)   *H01L 35/32* (2006.01)
*B82Y 30/00* (2011.01)   *C23C 16/04* (2006.01)
*H01M 4/134* (2010.01)

(86) International application number:
**PCT/ES2016/070421**

(87) International publication number:
**WO 2016/198712 (15.12.2016 Gazette 2016/50)**

(54) **NANOSTRUCTURES OF CONCENTRIC LAYERS**

NANOSTRUKTUREN MIT KONZENTRISCHEN SCHICHTEN

NANOSTRUCTURE À FEUILLES CONCENTRIQUES

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **08.06.2015 ES 201530798**

(43) Date of publication of application:
**11.04.2018 Bulletin 2018/15**

(73) Proprietor: **FUNDACIÓ INSTITUT DE RECERCA
EN ENERGIA DE CATALUNYA
08930 Barcelona (ES)**

(72) Inventors:
• **MORATA GARCÍA, Alejandro**
**08930 Sant Adrià De Besòs (ES)**
• **TARANCÓN RUBIO, Alberto**
**08930 Sant Adrià De Besòs (ES)**
• **GADEA DÍEZ, Gerard**
**08930 Sant Adrià De Besòs (ES)**

(74) Representative: **Ponti & Partners, S.L.P
C. de Consell de Cent 322
08007 Barcelona (ES)**

(56) References cited:
WO-A1-2009/121171   WO-A1-2015/023760
WO-A2-2010/138617   CN-A- 1 102 711
US-A1- 2006 102 224

• SATISHKUMAR B C ET AL: "Oxide nanotubes prepared using carbon nanotubes as templates", JOURNAL OF MATERIALS RESEARCH, MATERIALS RESEARCH SOCIETY, WARRENDALE, PA, US, vol. 12, no. 3, 1 March 1997 (1997-03-01), pages 1-3, XP002504654, ISSN: 0884-2914
• JIE CHEN ET AL: "Remarkable Reduction of Thermal Conductivity in Silicon Nanotubes", NANO LETTERS, vol. 10, no. 10, 13 October 2010 (2010-10-13), pages 3978-3983, XP055311636, US ISSN: 1530-6984, DOI: 10.1021/nl101836z
• ZHENYI ZHANG ET AL: "In situ assembly of well-dispersed gold nanoparticles on electrospun silica nanotubes for catalytic reduction of 4-nitrophenol", CHEMICAL COMMUNICATIONS - CHEMCOM., vol. 47, no. 13, 1 January 2011 (2011-01-01), page 3906, XP055311771, ISSN: 1359-7345, DOI: 10.1039/c0cc05693f
• JIANG-WEI ZHANG ET AL: "Preparation of silicon nitride hollow fibre membrane for desalination", MATERIALS LETTERS, ELSEVIER, AMSTERDAM, NL, vol. 68, 12 November 2011 (2011-11-12), pages 457-459, XP028351766, ISSN: 0167-577X, DOI: 10.1016/J.MATLET.2011.11.041 [retrieved on 2011-11-22]
• CHAUDHURI SUBHASIS ET AL: "Hollow core silicon-silica Bragg fiber", 2015 CONFERENCE ON LASERS AND ELECTRO-OPTICS (CLEO), OSA, 10 May 2015 (2015-05-10), pages 1-2, XP033194438, DOI: 10.1364/CLEO_SI.2015.STU1N.5 [retrieved on 2015-08-10]

**EP 3 306 685 B1**

**(Cont. next page)**

Remarks:
The file contains technical information submitted after the application was filed and not included in this specification

Remarks:
The file contains technical information submitted after the application was filed and not included in this specification

## Description

### Field of invention

The present invention relates to nanostructures. In particular, it relates to nanostructures composed of concentric layers of silicon or germanium.

### Background of the invention

The clean and sustainable energy supply for the industrial and domestic consumption is one of the main challenges in the current socio-economic scenario. The goverments of developed countries are carryin out policies devoted to promote new energy sources that must adjust to criteria based on environment protection. However, in Europe, still today a third of the produced energy is disipated in the form of heat before reaching the final consumer. The most important losses are produced in the generation process. It would be desirable to achieve a transformation of this residual heat in electrical energy for an in-situ use (supply for sensors and acutators, communication etc.) or its incorporation to the electrical network.

The thermoelectric devices are solid candidates to play the role of transforming thermal energy into electricity. Among its advantages, they count with a high simplicity, absence of mobile parts, adaptability to a range of temperature differences and capacity for long-term operation for long periods of time. However, up to now, its implementation has been restricted to a limited number of applications due to the high cost and the scarcity and toxicity of the best performing materials.

The thermoelectric effect consists in the generation of electricity from a temperature gradient. This phenomena allows transforming the energy proceding from a residual hot source into electric energy. The ability of a thermoelectric material to generate electrical energy depends on its Seebeck coefficient (S). This is defined as the potential difference produced per unit temperature difference. Usually the dimensionless thermoelectric figure of merit is used to define the performance of a device. This is defined as follows:

$$ZT = \frac{S^2 \sigma T}{k} \qquad (1)$$

where T is the temperature, $\sigma$ is the electrical conductivity and k is the thermal conductivity. Thus the higher ZT, the greater conversion efficiency $\varepsilon$:

$$\varepsilon = \left[ \frac{\sqrt{1 + ZT_M} - 1}{\sqrt{1 + ZT_M} + (T_C/T_H)} \right] \frac{T_H - T_C}{T_H} \qquad (2)$$

Where $T_H$, $T_C$ and $T_M$ are the temperatures of the hot side, the cold side and the average defined as $T_M = (T_H + T_C)/2$, respectively.

Following equations 1 and 2 one can see that an efficient thermoelectric material must meet the following: having a high Seebeck coefficient, a high electrical conductivity and a low thermal conductivity. Besides it must be able to withstand high temperature gradients. This combination of properties has led researchers to face a complex puzzle. For example a material with high ZT must exhibit two qualities that hardly occur simultaneously in nature: low thermal conductivity and high electrical conductivity. One approach is to search for combinations of elements that could lead to material with better attributes. So far, the top positions are occupied by very scarce and pollutant materials ($Bi_2Te_3$, PbTe etc.). For this reason large-scale application of thermoelectric devices has not still been achieved.

In order to overcome the problems of the state of the art, the present inventors have developed a new material consisting of a nanostructure composed of silicon or germanium woven sheets. Surprisingly, the present inventors have also observed that different variants of such nanostructure lead to properties not just related to the thermoelectric effect, but to other applications such as solar cells, lithium batteries, etc.

Similar materials are described in the literature, e.g., silicon nanotubes described by Hui Wu et al. in Nature Nanotechnology Vol. 7, p. 310-315. In this publication amorphous nanotubes are obtained with application as battery anodes capable to provide great load capacities. It is well known that amorphous silicon presents a very low electrical conductivity in comparison to crystalline or polycrystalline silicon for any degree of doping. This fact coupled with partial oxidation of the threads would make impossible using such structures in thermoelectric applications, or in any other involving electron transport.

Satishkumar B C et al. "Oxide nanotubes prepared using carbon nanotubes as templates", Journal of Materials Research, Materials Research Society, Warrendale, PA, US, Vol. 12, no. 3, 1 March 1997, pages 1-3, discloses a nanostructure which is composed of one layer around a carbon or vacuum core, comprising said one layer at least silicon oxide. This document further discloses a method for manufacturing a nanostructure comprising silicon oxide.

### Brief description of the drawings

Figure 1 schematically describes a cross section of the nanostructure of the invention, in which 1 refers to the empty core or carbon; 2 is the first deposited coating; 3 is the second deposited coating and 4 is the third deposited coating.

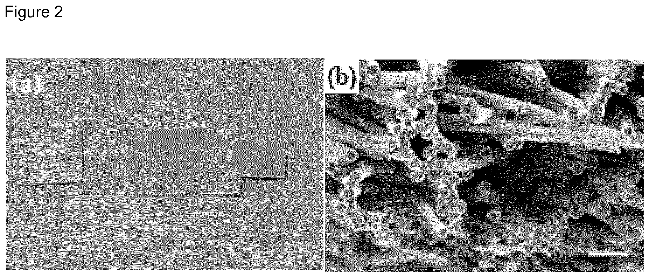

Figure 2. carbon nanofibres coated with a silicon layer. (A) Image after the coating process in the reactor chamber. (B) Detail section obtained by scanning electron microscopy. Scale bar size is 2 microns.

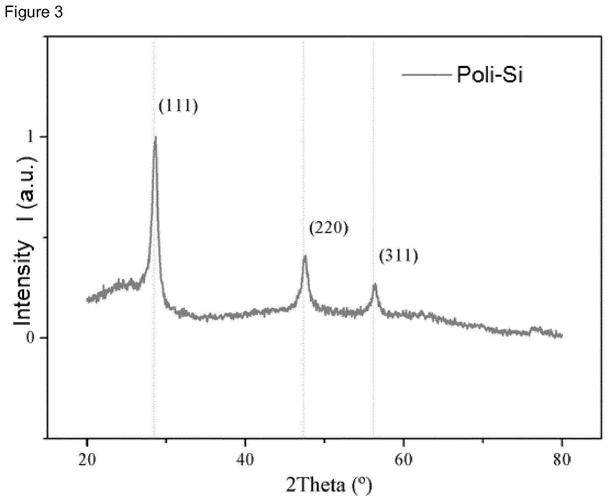

Figure 3. Diffractogram obtained by X-ray diffraction. The sample analyzed was a polysilicon nanotube fiber grown 650 C for 30 minutes using silane as gas precursor. The lines correspond to the expected positions for the indicated crystal planes. This result demonstrates the polycrystalline nature of the nanotube.

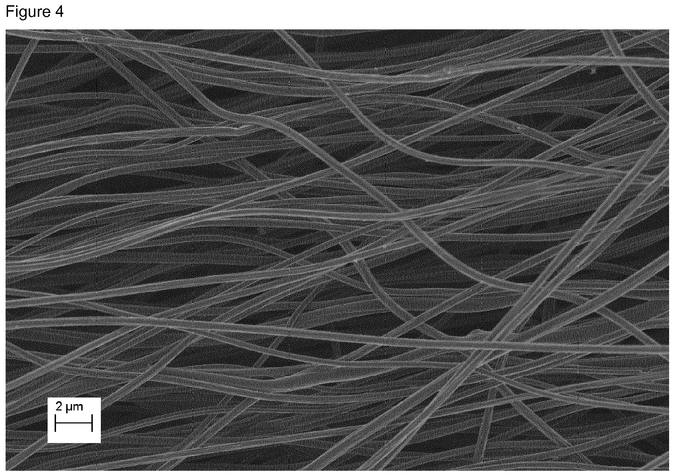

Figure 4. Electron microscopy image showing the polysilicon nanotube fibers.

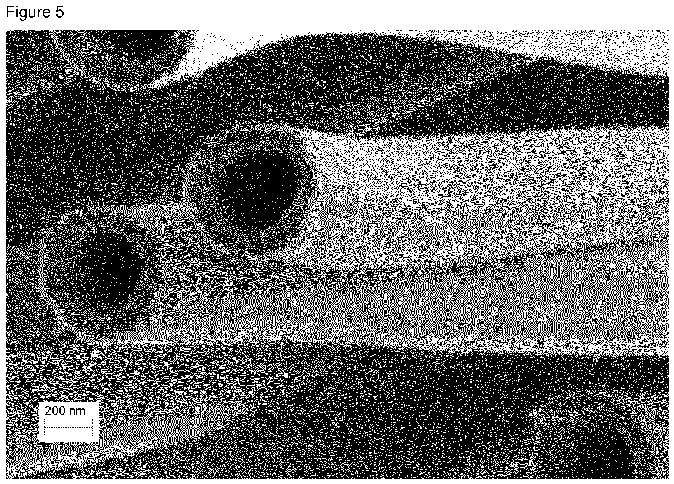

Figure 5. Cross section of doped silicon nanotube fibers. It can be seen that the nanotubes are composed of silicon nanoparticles, forming a continuous surface of polycrystalline silicon.

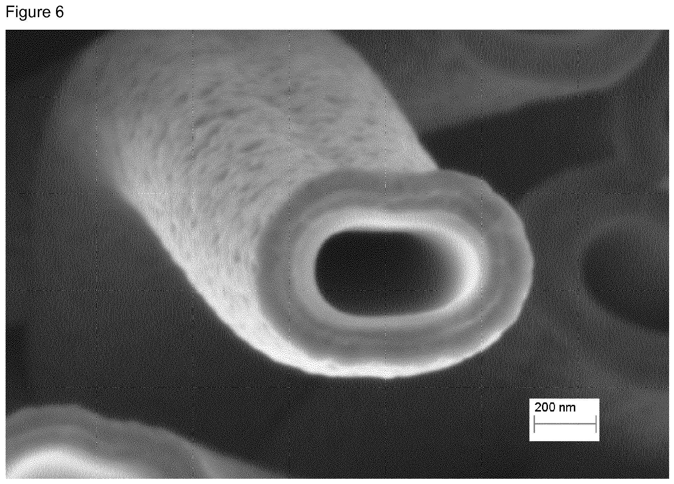

Figure 6. Electron microscopy image of a cross section of a nanotube composed of three concentric layers: an inner layer of n-type doped silicon, an intermediate layer of silicon oxide and an outer layer of p-type doped silicon. In this case, the core carbon that supported the fiber during silicon growth was removed by a heat treatment.

Figure 7: (A) Lithium insertion and extraction cycles of a sheet formed by intrinsic polysilicon nanotubes carbon with core. (B) The picture shows the microstructure of this material.

Figure 8: (A) Power curve obtained by placing the device on a hot surface. (B) Scanning electron microscopy images of fiber section at different magnifications.

Figure 9: Silicon nanotubes with gold particles on the surface.

Figure 10: Silicon nanotubes with gold particles on the surface after nanowire growth from nanoparticles.

## Summary of the invention

The present invention relates to a nanostructure as defined in the set of claims.
The present invention also relates to a method of manufacturing the nanostructure disclosed herein.
Additionally the present invention relates to the use of variants of the nanostructure as defined in the set of claims in thermoelectricity, as solar cells, in the manufacture of lithium batteries, as gas sensors or as diodes for producing light.

## Detailed description of the invention

In a first aspect, the present invention relates to a nanostructure composed of one or multiple concentric layers around a carbon or vacuum core, comprising said one or multiple concentric layers at least one of the following components in crystalline or polycrystalline form: intrinsic silicon, intrinsic germanium, p or n doped silicon, p or n doped germanium, intrinsic silicon-germanium alloys, p or n doped silicon-germanium alloys, silicon oxide, germanium oxide, silicon nitride, germanium nitride or a combination thereof, characterized in that said nanostructure comprises metal particles attached by means of nanowires to at least one of said concentric layers or in that said nanostructure comprises holes in at least one of said concentric layers, which holes correspond to previously deposited metal particles which have been removed.

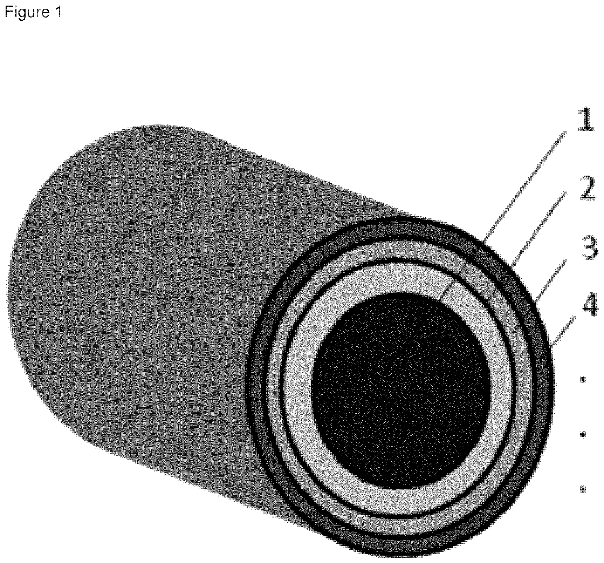

Figure 1 illustrates such aspect of the invention in a detailed fashion by showing three coatings or concentric layers around vacuum or carbon core. The composition of these coatings or concentric layers is indicated above, but the composition of a coating or layer may be the same or different from another coating or layer within the same structure.
In the present invention the terms "coating" or "layer" are interchangeably used to refer to the surface that concentrically surrounds the core of the nanostructure disclosed herein. In a broader three-dimensional view many of these coatings or layers surrounding the core are in the form of fibers. It should be clear that the structures presented herein are not core-shell structures where concentric spheres are used.
In another preferred embodiment, said nanostructure, according to any of the aforementioned embodiments, is attached through a nanowire to another nanostructure as defined in any of the above embodiments.
Preferably said metal particles are particles of gold, silver and/or tin and preferably, said nanowires are made of silicon or germanium, optionally p-type or n-type doped.
In a second aspect, the present invention relates to a method of manufacturing a nanostructure as defined in claim 5, comprising the steps of:

(a) providing one or more layers made of carbon fibers forming a substrate;
(b) introducing the substrate into a chemical vapour deposition equipment (CVD) for depositing silicon or germanium or alloys thereof, optionally p or n doped, and optionally in the form of nitrides;
(c) performing one of the following substeps after removing the substrate from the CVD equipment:

- (c2) adding, reacting, or melting metal particles on at least one of the concentric layers;
- (c3) removing the core;
- (c4) oxidizing the surface of at least one of the concentric layers;

- (c5) creating holes from previously added particles on at least one of the concentric layers;
- (c6) a combination of two or more of (c2) to (c5);

(d) in the case of (c2) through (c6), reintroducing the nanostructure in a CVD equipment for creating one or more layers by deposition of silicon or germanium or alloys thereof, optionally p or n doped, and optionally in the form of nitrides or for creating nanowires from the particles;

(e) removing the final nanostructure or repeating one or more of the substeps (c2) - (c6) and step (d) until obtaining the desired nanostructure.

In the present context "substrate" is understood as the nanostructure in its previous forms prior to constitute the final nanostructure.

Regarding step (a), an example of the use of carbon fibers as substrate is a fiber manufactured by the technique known as electrospinning. The fibers are formed from a solution of polyacrylonitrile based polymers and introduced in an electrospinning equipment that generates a droplet subjected to a high electric field towards a substrate holder. The holder may be kept still, or moving in a plane perpendicular to the ejection direction of the polymer, or rotate or generate any movement which will determine the relative arrangement between eslectrospun fibers: random, aligned, crossed etc. Subsequently, the fibrous tissue resulting from this process is subjected to various calcination processes. A first process is conducted in air at a temperature below 400 ° C and a second one in a reducing or oxygen-free atmosphere at a temperature between 900 and 1600 ° C, depending on the degree of crystallinity desired in the resulting carbon. Another example is an airgel substrate consisting of carbon material formed by a nanometric pores.

Regarding step (b), the process is performed within a sealed chamber, wherein the substrate is exposed to oxygen freee atmospheres and reactive gases that result in deposition of a layer of silicon and/or germanium on the susbtrate surface. The reagents that lead to the deposition may come from various sources, typically silane ($SiH_4$), germane ($GeH_4$), disilane ($Si_2H_6$), trichlorosilane (SiHCl3) etc. Additionaly doping of the deposited layer may be achieved by introducing elements generating energy sates close to the valence or conduction shell of silicon, germanium or silicon-germanium alloy. Examples of these elements are boron, which can be introduced by adding diborane ($B_2H_6$) during or after growth of the layers of silicon and/or germanium and phosphorus, which can be introduced similarly by using a gas such as phosphine ($PH_6$). The growth process is dependent on the chosen precursors but in any respect requires addition of energy, either as heat by elevated temperatures, either through the plasma assistance. Reducing the pressure in the chamber improves process control. The deposition temperature depends on the chosen precursor. If we take the example of silane gas based silicon deposition, the layers can be generated using a temperature bewteen 580 and 750 °C, total pressures between 0.5 and 200 Torr, a silane flow between 2 and 100 standard cubic centimetres per minute (sccm) and a flow between 100 and 5000 sccm of carrier gas (hydrogen or argon). Incorporation of boron doping in the deposited layer can be achieved by using very low diborane partial pressures in the gas flow, in the range of 1 to 100 parts per million with respect to the total pressure. The selection of the parameters within the proposed range of conditions allows adjusting properties such as the size of the crystal particles forming the layer and the thickness or conductivity of the latter.

With respect to step (c3), removing the carbon core can be achieved by a heat treatment bewteen 400 and 900°C. Alternatively, chemical methods may be used to remove this core, such as acids or bases capable of dissolvinge carbon or plasma. It is noted that heat treatment at these high temperatures in the presence of ambient oxygen may induce silicon or germanium oxide on the layer surface.

In a third aspect, the present invention relates to the use of the nanostructure described according to the first aspect of the invention.

Firstly, the nanostructure can be used as a thermoelectric device, wherein the concentric layers surrounds an empty core and the silicon or gemanium forming the layers are in doped form, optionally interspersed by silicon or germanium oxides.

In this case the low thermal conductivity of nanostructured silicon and/or germanium and its high electrical conductivity and Seebeck coefficient are exploited. A part of the structure is put in contact with a medium at a given temperature while simultaneously another part of is put in conatct to a medium with a different temperature. The temperature difference results in a current which can be exploited if the appropriate electrical contacts are placed. The flexibility of the fibers and the ability to adapt to the shape of curved or irregular surfaces is an added advantage.

A major efficiency may be obtained by joining one end of the structure with Si/Ge/Si-Ge with a determined p or n doping level with another structure with silicon/germanium/Si-Ge with a with a different p or n doping level than the former.

The same effect can be obtained if a structure composed of fibers with three layers is generated: Si/Ge/Si-Ge with a determined p or n doping level, Si/Ge/Si-Ge oxide and Si/Ge/Si-Ge with a different p or n doping level. The inner and outer sheets are electrically insulated by the intermediate oxide layer. These two layers are electrically joined at one end of the fiber, which is subjteced to a determined temperature, whereas at the opposite end the layers are electrically separated and subjected to a different temeprature. Therefore, one can use the energy from the Seebeck generated current by conatcting the sheets at the separated side.

The growth of nanowires contacting different surfaces allows making use of well known thermoelectric properties with these structures, particularly when aiming to exploit the temperature difference between two surfaces of flat fibers.

Secondly, the nanostructures can be used as solar cells.

It is known that in the junction region between semiconductor layers of different metals or semiconductors a so called depletion region is generated, with a local electric field. When photons strike in such region and generate electron-hole pairs the electric field of the depletion zone separates these carriers generating a current and a potential difference able to generate power. This is the mechanism used in solar cells. A nanostructure as described herein with varying degrees of doping in each of the concentric layers resulting in a diode as described would generate current when exposed to light.

Thirdly, the nanostructure can be used in the manufacture of lithium batteries.

Silicon is a good electrode for lithium batteries. A major problem for its commercialization is the generation of an insulating layer of different volume which tends to destroy the surface and to deactivate the electrodes in few charge-discharge cycles. A possibility to increase durability is to generate silicon bearing structures, which allow exposing silicon surface but not its expansion. Using silicon oxide as bearing structure in the proposed nanostructures could increase the durability of silicon as electrode.

A useful variant could nanostructure as the ones described herein with gold particles crossing the first layer of silicon and reaching the electrically conductive carbon core. To this purpose Au nanoparticles can be deposited on the silicon layer and annealed to temperatures avobe Au-Si eutectic point (363 °C). The liquid eutectic droplets generated this way solidify again to gold nanoparticles crossing the silicon layer as decribed. These particles represent an electrical contact without losing structural strength. The introduction of the particles in first place could be attained by exposing the fibers to a colloidal suspension of gold or by selective displacement techniques such as electroplating or electroless gold deposition following by thermal annealing.

Another variant would consist in removing the aforementioned crossing gold nanoparticles by chemical methods, which would lead to the generation of ducts that would facilitate the flow of liquid electrolyte to the carbon core with minimal loss of structural strength.

Fourthly, the nanostructure can be used as gas sensor. The large surface of the nanostructure and its easy functionalization by placing surface particles allows a fast reactivity with the surrounding atmosphere and therefore its application as a gas sensor.

Fifthly, the nanostructure can be used as diodes for emitting light. The possibility of generating different semiconducting layers electrically contacted by a conductive core would generate diodes that could ultimately produce light. The introduction of nanoparticles on the surface (ie, with photoluminescence properties) might lead to a variety of wavelengths.

Next, the present invention is illustrated by the following examples which in no way intend to limit the scope of the present invention.

## EXAMPLES

Fabrication of carbon nanofiber layers

The starting material for the manufacture of fibers are powders of polyacrylonitrile (PAN) of molecular weight 150,000 g/mol (Sigma Aldrich) and N,N-dimethylformamide (DMF) as solvent (Panreac). A solution of 10% mass concentration PAN in DMF was prepared by constant stirring at 80° C for 2 hours until complete dissolution. This solution was filled in a syringe terminating in a stainless steel needle of 0.6 mm internal diameter which was placed on acommercial electrospinning equipment (Nanotechnology Solutions, Yflow®). The solution injected through the needle at a rate of 2.2 ml/h on a rotating substrate wherein a potential of 1.5 kV/cm was applied. Therefore fabrics or surfaces of PAN nanofibers with areas reaching 2000 cm$^2$ were fabricated.

The material was cut into the desired shape and dimensions and subjected to a first stabilization process in air at a temperature of 170° C. A second process at high temperature (1000° C) in a reducing atmosphere leaded to the carbonization of the fibers.

Manufacture of doped silicon layers

Fibers made by electrospinning and carbonized were placed in a commercial low-pressure chemical vapor deposition reactor (FirstNano EasyTube® 3000). The deposition was produced at a temperature of 600° C at a pressure of 5 Torr by simultaneously introducing a flow of 50 sccm silane ($SiH_4$) and 50 sccm hydrogen-diluted diborane ($B_2H_6$). Removal of dopant gas flow generated an intrinsic silicon layer. When desired, silicon was replaced by germanium (Ge), by using the same procedure as for silicon with germane ($GeH_4$) instead of silane, but reducing the deposition temperature at 300° C.

*Variant 1: multi-layer carbon core.*

At this point, a second layer of e.g. n-type doped silicon can be generated by changing the dioborane flow by an equivalent flow of phosphine ($PH_3$). Successive cycles equivalent to the aforementioned resulted in a succession of concentric layers that may be composed of intrinsic or doped Si or Ge chosen depending on the precursor and dopant gases.

*2. Multilayer variant with hollow core.*

A commonly variant used in the manufacture of thermoelectric devices involves extracting carbon the core from a silicon layer over-carbon core fiber. These samples were subjected to a combustion process in air at temperatures above 600° C to remove carbon fiber core, simultaneously causing the oxidation of silicon. Therefore silicon oxide nanotubes were ontained. These were used subsequently as a substrate in a new deposit of doped silicon or germanium, which rendered the fiber conductive and suitable for electronic appliacions again.

*Variant 3. Intermediate layer silicon oxide.*

In the case of desiring the interposition of a layer of silicon or germanium oxide, a common procedure is formaing it on the nanofibers described herein by exposure to an infrared pulse in a microwave rapid thermal oxidation oven (RTO) that subjects surface at temperatures above 900° C.

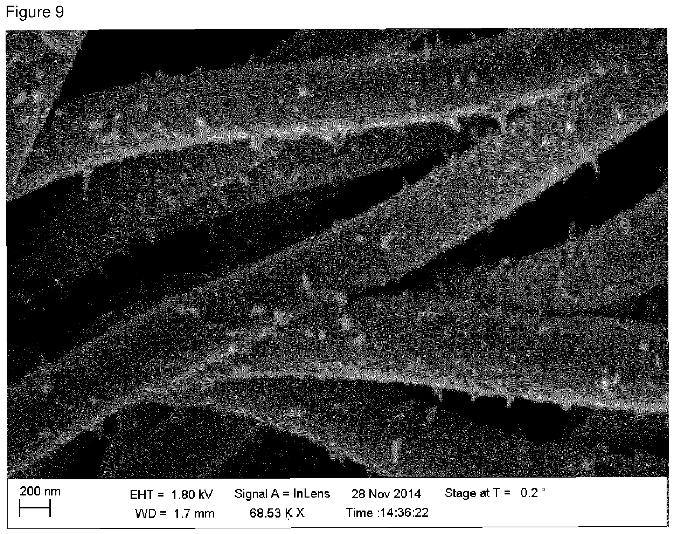

*Variant 4. Surface functionalization with metal nanoparticles. (Figure 9)*

The functionalization of the surfaces by metal particles is desirable for certain applications. Therefore it is possible to introduce them by impregning the fibers in gold nanoparticles suspensions or using a controllable deposition technique such as gold galvanic displacement (also known as gold electroless deposition). In the first case a commercial solution of soabilized gold nanoparticles was employed, with diameters between 10 and 150 nm and concentrations between $10^9$ and $10^{11}$ particles/ml. The fibers were impregnated with 1.5 ml of this solution and allowed to dry. This way it was ensuried that the nanoparticles would eventually deposit on the walls of the silicon nanotubes. The amount of deposited particles could be controlled by performing several impregnation-drying stages (to increase the amount) or dilution of the colloidal suspension (to decrease the amount). In the case of gold galvanic displacement a higher volume aqueous solution of gold salt (usually $NaAuCl_4$) with hydrofluoric was used, so that the silicon fiber could be completely immersed. During immersion an oxidation-reduction reaction occurs between the fiber silicon, which oxidizes and dissolves $SiF_6^{2-}$, and the gold cation $Ag^{3+}$, which is reduced and deposited as solid gold on the surface of the nanotubes. After a certain time of immersion the fibers were rinsed in water to stop the reaction and remove excess reagents. The immersion time and concentration of gold in the solution determine the amount of gold deposited.

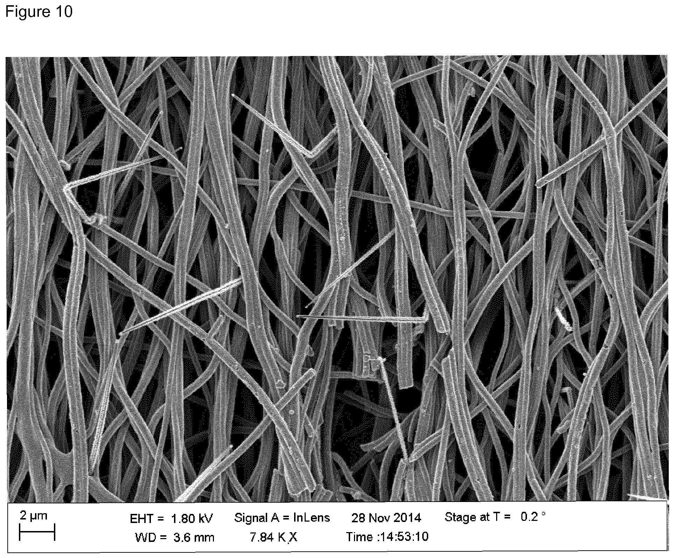

*Variant 5. Surface functionalization with nanowires. (Figure 10).*

If desired, silicon or germanium nanowires can be grown in the samples that present metal nanoparticles on the surface, as explained above. For this they are introduced into the aforementioned chemical vapour deposition reactor. They are subjected to a temperature of 630° C and a pressure of 5 Torr. Flows of 200 sccm of silane or germane and 5 to 50 sccm of dopant precursors are introduced, toghjether with 10-1000 sccm. Simultaneously, between 10 and 100 sccm of hydrogen chloride are introduced to prevent the formation of polysilicon.

Application as an anode material of lithium ion battery.

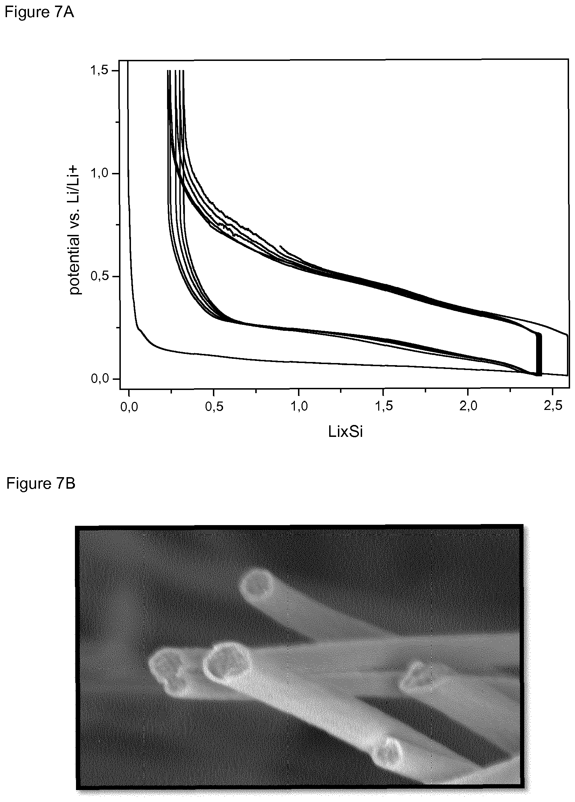

Nanometric carbon fibers coated with intrinsic siliconwere were used as a lithium ion battery electrode. Microscopically these fibers exhibited a significant degree of alignment, through the use of a rotating substrate during deposition. They had an average diameter of 200 nm, and a polysilicon layer thickness of 50 nm. Macroscopically the structures were fabricated as thin sheet of 30 micron thickness and five square centimeters. This sheet was cut into a circle of 1 cm diameter and introduced into a measuring chamber in which a liquid electrolyte (1EC (ethylene carbonate): 3DMC (dimethyl carbonate)) is added. Insertion and removal of lithium in the material is forced by applying a potential. In Figure 7 the insertion/withdrawal cycles are showed, demonstrating the actual applicability of this material as an anode of a lithium ion battery.

Applicaction as a thermoelectric material

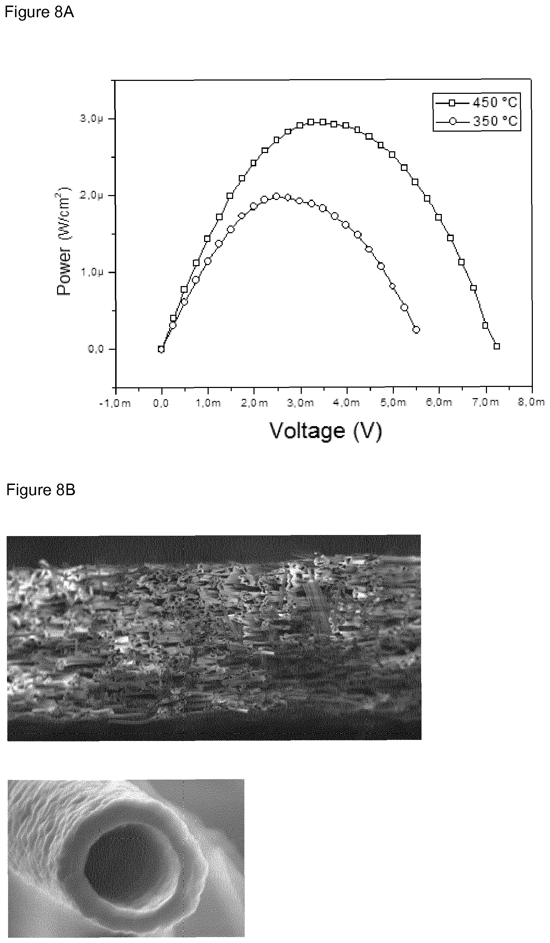

A sheet of silicon nanotube fibers was employed as a thermoelectric device, taking advantage of its ability to obtain electrical power from a hot surface. The material consists at the microscopic level in hollow tubes with two concentric layers. An inner thin layer of silicon oxide and an outer p-type doped silicon. Macroscopically the dimensions of the sheet are 20 mm long, 3 mm wide and 0.01 mm thick. An end of the device was placed on a hot surface while the opposite end was placed on a surface at lower temperature. We measured the power obtained at different temperatures (see Figure 8).

**Claims**

1. Nanostructure composed of one or multiple concentric layers around a carbon or vacuum core, comprising said one or multiple concentric layers at least one of the following components in crystalline or polycrystalline form: intrinsic silicon, intrinsic germanium, p or n doped silicon, p or n doped germanium, intrinsic silicon-germanium alloys, p or n doped silicon-germanium alloys, silicon oxide, germanium oxide, silicon nitride, germanium nitride or a combination thereof, **characterized in that** said nanostructure comprises metal particles attached by means of nanowires to at least one of said concentric layers or **in that** said nanostructure comprises holes in at least one of said concentric layers, which holes correspond to previously deposited metal particles which have been removed.

2. Nanostructure according to claim 1, which is attached through a nanowire to another nanostructure as defined in claim 1.

3. Nanostructure according to any of claims 1 or 2, wherein said metal particles are particles of gold, silver and/or tin.

4. Nanostructure according to any of claims 1 to 3, wherein the nanowires are made of silicon or germanium, optionally p-type or n-type doped.

5. Method for manufacturing a nanostructure according to claim 1 composed of one or multiple concentric layers around a carbon or vacuum core, comprising said one or multiple concentric layers at least one of the following components in crystalline or polycrystalline form: intrinsic silicon, intrinsic germanium, p or n doped silicon, p or n doped germanium, intrinsic silicon-germanium alloys, p or n doped silicon-germanium alloys, silicon oxide, germanium oxide, silicon nitride, germanium nitride or a combination thereof, wherein

   - said nanostructure comprises holes in at least one of said concentric layers, which holes correspond to previously deposited metal particles which have been removed; or
   - said nanostructure comprises metal particles attached by means of nanowires to at least one of said concentric layers; optionally wherein said nanostructure comprises metal particles on at least one of said concentric layers or said particles are reacted or partially molten with the layers; or

   wherein said nanostructure is optionally attached through a nanowire to another of said nanostructure, the method comprising the steps of:

   (a) providing one or more layers made of carbon fibers forming a substrate;
   (b) introducing the substrate into a chemical vapour deposition equipment (CVD) for depositing silicon or germanium or alloys thereof, p or n doped, and optionally in the form of nitrides;
   (c) performing one of the following substeps after removing the substrate from the CVD equipment:

      - (c2) adding, reacting, or melting metal particles on at least one of the concentric layers;
      - (c3) removing the core;
      - (c4) oxidizing the surface of at least one of the concentric layers;
      - (c5) creating holes from previously added particles on at least one of the concentric layers;
      - (c6) a combination of two or more of (c2) to (c5);

   (d) in the case of (c2) through (c6), reintroducing the nanostructure in a CVD equipment for creating one or more layers by deposition of silicon or germanium or alloys thereof, p or n doped, and optionally in the form of nitrides or for creating nanowires from the particles;
   (e) removing the final nanostructure or repeating one or more of the substeps (c2) - (c6) and step (d) until obtaining the desired nanostructure.

6. Use of a nanostructure according to claim 1, as thermoelectric device, wherein the concentric layers are around an empty core and the silicon or germanium forming the layers are in doped form.

7. Use of a nanostructure according to any of claims 1 to 4, as solar cells.

8. Use of a nanostructure according to any of claims 1 to 4 in the manufacture of lithium batteries.

9. Use of a nanostructure according to any of claims 1 to 4, as gas sensor.

10. Use of a nanostructure according to any of claims 1 to 4 as diodes for producing light.


**Patentansprüche**

1. Nanostruktur, zusammengesetzt aus einer oder mehreren konzentrischen Schichten um einen Kohlenstoff- oder Vakuumkern, wobei die eine oder die mehreren konzentrischen Schichten mindestens eine der folgenden Komponenten in kristalliner oder polykristalliner Form umfassen: intrinsisches Silicium, intrinsisches Germanium, p- oder n-dotiertes Silicium, p- oder n-dotiertes Germanium, intrinsische Silicium-Germanium-Legierungen, p- oder n-dotierte Silicium-Germanium-Legierungen, Siliciumoxid, Germaniumoxid, Siliciumnitrid, Germaniumnitrid oder eine Kombination davon, **dadurch gekennzeichnet, dass** die Nanostruktur Metallpartikel umfasst, die mittels Nanodrähten an mindestens einer der konzentrischen Schichten angebracht sind, oder dass die Nanostruktur Löcher in mindestens einer der konzentrischen Schichten umfasst, wobei die Löcher zuvor abgeschiedenen Metallpartikeln entsprechen, die entfernt wurden.

2. Nanostruktur nach Anspruch 1, die über einen Nanodraht an einer weiteren Nanostruktur, wie in Anspruch 1 definiert, angebracht ist.

3. Nanostruktur nach einem der Ansprüche 1 oder 2, wobei es sich bei den Metallpartikeln um Partikel aus Gold-, Silber und/oder Zinn handelt.

4. Nanostruktur nach einem der Ansprüche 1 bis 3, wobei die Nanodrähte aus Silicium oder Germanium, optional p- oder n-dotiert, gefertigt sind.

5. Verfahren zum Herstellen einer Nanostruktur nach Anspruch 1, die aus einer oder mehreren konzentrischen Schichten um einen Kohlenstoff- oder Vakuumkern zusammengesetzt ist, wobei die eine oder die mehreren konzentrischen Schichten mindestens eine der folgenden Komponenten in kristalliner oder polykristalliner Form umfassen: intrinsisches Silicium, intrinsisches Germanium, p- oder n-dotiertes Silicium, p- oder n-dotiertes Germanium, intrinsische Silicium-Germanium-Legierungen, p- oder n-dotierte Silicium-Germanium-Legierungen, Siliciumoxid, Germaniumoxid, Siliciumnitrid, Germaniumnitrid oder eine Kombination davon, wobei

- die Nanostruktur Löcher in mindestens einer der konzentrischen Schichten aufweist, wobei die Löcher zuvor abgeschiedenen Metallpartikeln entsprechen, die entfernt wurden; oder
- die Nanostruktur Metallpartikel umfasst, die mittels Nanodrähten an mindestens einer der konzentrischen Schichten angebracht sind;

wobei die Nanostruktur optional Metallpartikel an mindestens einer der konzentrischen Schichten umfasst oder die Partikel mit den Schichten umgesetzt oder partiell verschmolzen sind; oder
wobei die Nanostruktur optional über einen Nanodraht an einer weiteren Nanostruktur angebracht ist, wobei das Verfahren die Stufen umfasst:

(a) Bereitstellen von einer oder mehreren Schichten von Kohlenstofffasern, die ein Substrat bilden;
(b) Einführen des Substrats in eine Vorrichtung zur chemischen Gasphasenabscheidung (CVD-Vorrichtung) zum Abscheiden von Silicium oder Germanium oder Legierungen davon, p- oder n-dotiert, und optional in Form von Nitriden vorliegen;
(c) Durchführen von einer der folgenden Unterstufen nach Entnehmen des Substrats aus der CVD-Vorrichtung:

- (c2) Zugeben, Umsetzen oder Schmelzen von Metallpartikeln zu bzw. mit mindestens einer der konzentrischen Schichten;
- (c3) Entfernen des Kerns;
- (c4) Oxidieren der Oberfläche von mindestens einer der konzentrischen Schichten;
- (c5) Erzeugen von Löchern aus den zuvor zugegebenen Partikeln an mindestens einer der konzentrischen Schichten;
- (c6) Kombinieren von zwei oder mehr der Stufen (c2) bis (c5);

(d) im Fall von (c2) bis (c6) erneutes Einführen der Nanostruktur in eine CVD-Vorrichtung zum Erzeugen von einer oder mehreren Schichten durch Abscheidung von Silicium oder Germanium oder von Legierungen davon, p- oder n-dotiert, und optional in Form von Nitriden vorliegen, oder zum Erzeugen von Nanodrähten aus den Partikeln;
(e) Entnehmen der fertigen Nanostruktur oder Wiederholen von einer oder mehreren Unterstufen (c2) bis (c6) und der Stufe (d), bis die angestrebte Nanostruktur erhalten worden ist.

6. Verwendung einer Nanostruktur nach Anspruch 1 als thermoelektrische Vorrichtung, wobei die konzentrischen Schichten um einen leeren Kern herum angeordnet sind und das Silicium oder Germanium, die die Schichten bilden, in dotierter Form vorliegen.

7. Verwendung einer Nanostruktur nach einem der Ansprüche 1 bis 4 als Solarzellen.

8. Verwendung einer Nanostruktur nach einem der Ansprüche 1 bis 4 bei der Herstellung von Lithiumbatterien.

9. Verwendung einer Nanostruktur nach einem der Ansprüche 1 bis 4 als Gassensor.

10. Verwendung einer Nanostruktur nach einem der Ansprüche 1 bis 4 als Dioden zur Erzeugung von Licht.

**Revendications**

1. Nanostructure composée d'une ou plusieurs couches concentriques autour d'un noyau de carbone ou de vide, lesdites une ou plusieurs couches concentriques comprenant au moins un des composants suivants sous forme cristalline ou polycristalline : silicium intrinsèque, germanium intrinsèque, silicium dopé p ou n, germanium dopé p ou n, alliages silicium-germanium intrinsèques, alliages silicium-germanium dopés p ou n, oxyde de silicium, oxyde de germanium, nitrure de silicium, nitrure de germanium ou une combinaison de ceux-ci ; **caractérisée en ce que** ladite nanostructure comprend des particules métalliques fixées au moyen de nanofils à au moins une desdites couches concentriques ou **en ce que** ladite nanostructure comprend des trous dans au moins une desdites couches concentriques, lesdits trous correspondant aux particules métalliques précédemment déposées qui ont été enlevées.

2. Nanostructure selon la revendication 1, qui est fixée par l'intermédiaire d'un nanofil à une autre nanostructure telle que définie dans la revendication 1.

3. Nanostructure selon l'une quelconque des revendications 1 ou 2, dans laquelle lesdites particules métalliques sont des particules d'or, d'argent et/ou d'étain.

4. Nanostructure selon l'une quelconque des revendications 1 à 3, dans laquelle les nanofils sont constitués de silicium ou de germanium, facultativement dopés de type p ou de type n.

5. Procédé de fabrication d'une nanostructure selon la revendication 1 composée d'une ou plusieurs couches concentriques autour d'un noyau de carbone ou de vide, lesdites une ou plusieurs couches concentriques comprenant au moins un des composants suivants sous forme cristalline ou polycristalline : silicium intrinsèque, germanium intrinsèque, silicium dopé p ou n, germanium dopé p ou n, alliages silicium-germanium intrinsèques, alliages silicium-germanium dopés p ou n, oxyde de silicium, oxyde de germanium, nitrure de silicium, nitrure de germanium ou une combinaison de ceux-ci, dans lequel

- ladite nanostructure comprend des trous dans au moins une desdites couches concentriques, lesdits trous correspondant aux particules métalliques précédemment déposées qui ont été enlevées ; ou
- ladite nanostructure comprend des particules métalliques fixées au moyen de nanofils à au moins une desdites couches concentriques ;

facultativement dans lequel ladite nanostructure comprend des particules métalliques sur au moins une desdites couches concentriques ou lesdites particules réagissent ou fondent partiellement avec les couches ; ou
dans lequel ladite nanostructure est facultativement fixée par l'intermédiaire d'un nanofil à une autre de ladite nanostructure, le procédé comprenant les étapes de :

(a) fourniture d'une ou plusieurs couches constituées de fibres de carbone formant un substrat ;

(b) introduction du substrat dans un équipement de dépôt chimique en phase vapeur (CVD) pour déposer du silicium ou du germanium ou des alliages de ceux-ci, dopés p ou n, et facultativement sous la forme de nitrures ;
(c) conduite de l'une des sous-étapes suivantes après le retrait du substrat de l'équipement CVD :

- (c2) ajout, réaction ou fusion de particules métalliques sur au moins une des couches concentriques ;
- (c3) retrait du noyau ;
- (c4) oxydation de la surface d'au moins une des couches concentriques ;
- (c5) création de trous à partir de particules précédemment ajoutées sur au moins une des couches concentriques ;
- (c6) une combinaison de deux ou plus parmi (c2) à (c5) ;

(d) dans le cas de (c2) à (c6), réintroduction de la nanostructure dans un équipement CVD pour créer une ou plusieurs couches par dépôt de silicium ou de germanium ou d'alliages de ceux-ci, dopés p ou n, et facultativement sous la forme de nitrures ou pour créer des nanofils à partir des particules ;
(e) retrait de la nanostructure finale ou répétition d'une ou plusieurs des sous-étapes (c2) à (c6) et de l'étape (d) jusqu'à l'obtention de la nanostructure souhaitée.

6. Utilisation d'une nanostructure selon la revendication 1, en tant que dispositif thermoélectrique, dans laquelle les couches concentriques sont autour d'un noyau vide et le silicium ou le germanium formant les couches sont sous forme dopée.

7. Utilisation d'une nanostructure selon l'une quelconque des revendications 1 à 4, en tant que cellules solaires.

8. Utilisation d'une nanostructure selon l'une quelconque des revendications 1 à 4 dans la fabrication de batteries au lithium.

9. Utilisation d'une nanostructure selon l'une quelconque des revendications 1 à 4, en tant que capteur de gaz.

10. Utilisation d'une nanostructure selon l'une quelconque des revendications 1 à 4 en tant que diodes pour produire de la lumière.

Figure 1

Figure 2

Figure 3

Figure 4

Figure 5

Figure 6

Figure 7A

Figure 7B

Figure 8A

Figure 8B

Figure 9

| 200 nm | EHT = 1.80 kV | Signal A = InLens | 28 Nov 2014 | Stage at T = 0.2 ° |
| | WD = 1.7 mm | 68.53 K X | Time :14:36:22 | |

Figure 10

| 2 μm | EHT = 1.80 kV | Signal A = InLens | 28 Nov 2014 | Stage at T = 0.2 ° |
| | WD = 3.6 mm | 7.84 K X | Time :14:53:10 | |

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **HUI WU et al.** *Nature Nanotechnology,* vol. 7, 310-315

- **SATISHKUMAR B C et al.** Oxide nanotubes prepared using carbon nanotubes as templates. *Journal of Materials Research, Materials Research Society,* 01 March 1997, vol. 12 (3), 1-3